**Europäisches Patentamt**

**European Patent Office**

**Office européen des brevets**

(11) Veröffentlichungsnummer: **0 141 207**
**A2**

(12) **EUROPÄISCHE PATENTANMELDUNG**

(21) Anmeldenummer: **84111069.5**

(22) Anmeldetag: **17.09.84**

(51) Int. Cl.⁴: **H 01 L 29/72**
**H 01 L 27/02**

(30) Priorität: **26.09.83 DE 3334774**

(43) Veröffentlichungstag der Anmeldung:
**15.05.85 Patentblatt 85/20**

(84) Benannte Vertragsstaaten:
**AT DE FR GB IT**

(71) Anmelder: **Siemens Aktiengesellschaft**
**Berlin und München Wittelsbacherplatz 2**
**D-8000 München 2(DE)**

(72) Erfinder: **Werner, Wolfgang, Dr.-Ing.**
**Lorenzonistrasse 66**
**D-8000 München 90(DE)**

(54) **Integrierbarer npn-Transistor.**

(57) Gegenstand der Erfindung ist ein integrierbarer npn-Siliciumtransistor, der sowohl im Aufwärtsbetrieb als auch im Abwärtsbetrieb einsetzbar ist und der trotz kleiner Abmessungen zu einem sehr niedrigen Basiswiderstand führt. Der beim Abwärtsbetrieb des Transistors dessen Emitter bildende n-leitende Bereich ist mit einem aus zwei Schichten bestehenden elektrischen Anschluß versehen. Dabei ist die an den n-leitenden Bereich angrenzende untere Schicht durch eine n⁺-dotierte polykristalline Siliciumschicht und die obere Schicht durch eine Verbindung mit einem der Metalle Tantal, Titan, Molybdän oder Wolfram gegeben. Dabei ist die zu kontaktierende Emitterzone unter Verwendung der polykristallinen Siliciumschicht des elektrischen Anschlusses zeitlich nach dessen Formung aus den bei den Schichten hergestellt worde, wozu die polykristalline Schicht des elektrischen Anschlusses als Diffusionsquelle verwendet worden ist. Diese Maßnahme führt zu sehr kleinen Emitterabmessungen, während die den polykristallinen Silicijmteil des Anschlußkontakts abdeckende Metallsilicidschicht für einen sehr kleinen Widerstand Rs sorgt.

FIG 2

## Integrierbarer npn-Transistor

Die Erfindung befaßt sich mit einem integrierbaren npn-Transistor mit niedrigem Basiswiderstand, der in einem einkristallinen Siliciumkörper erzeugt ist und bei dem die p-dotierte Basiszone an der einen Seite an einen ersten n-leitenden Bereich des Siliciumkörpers und an der gegenüberliegenden Seite an einen weiteren n-leitenden Bereich angrenzt, der von dem ersten n-leitenden Bereich getrennt ist und einen Kontakt aufweist, der teilweise aus $n^+$-dotiertem polykristallinen Silicium besteht und der als Dotierungsquelle bei der Herstellung des weiteren n-dotierten Bereiches verwendet wurde.

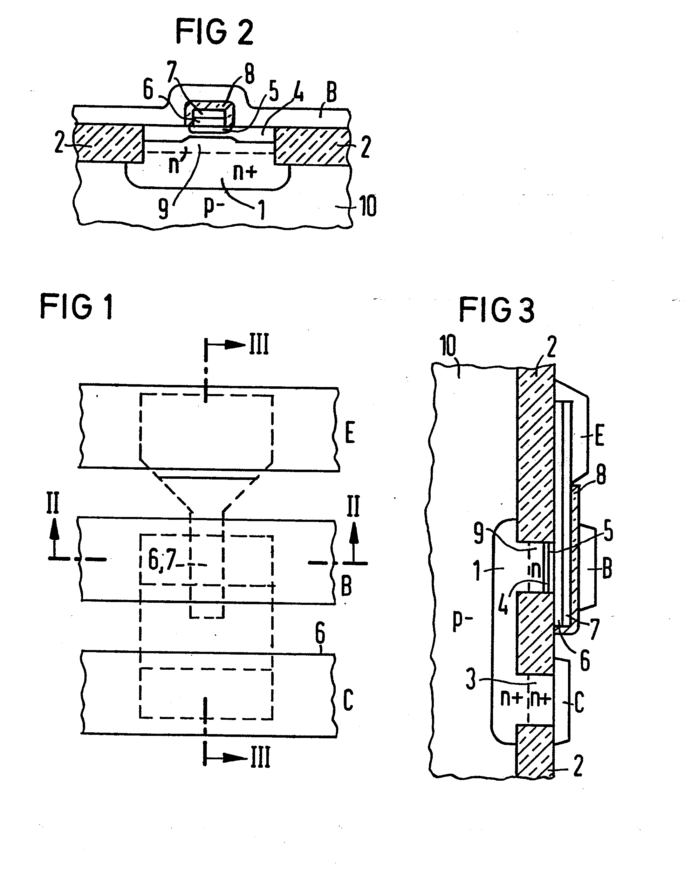

Eine solche Transistorstruktur ist in "IEDM 1979 Dig. Tech. Pap." S. 201 – 204 (vgl. S. 203, Fig. 2a) beschrieben und dargestellt. Dabei handelt es sich um eine "Self-aligned $I^2$L/MTL-Struktur", also um die Kombination eines vertikalen npn-Transistors mit einem lateralen pnp-Transistor, wobei die Basiszone des Vertikaltransistors mit der Kollektorzone des Lateraltransistors und die Emitterzone des Vertikaltransistors mit der Basiszone des Lateraltransistors identisch ist. Die Kollektorzonen des vertikalen npn-Transistors sind in Form von n-dotierten Inseln an der Oberfläche der Basiszone dieses Transistors erzeugt. Die Elektroden für die einzelnen Kollektorzonen des Vertikaltransistor bestehen jeweils aus einer mit Arsen $n^+$-dotierten Polysiliciumschicht. Der Vertikaltransistor wird also in der bei $I^2$L-Strukturen üblichen Weise im Aufwärtsbetrieb beschaltet.

Nun ist die Schaltzeit eines modernen Bipolartransistors im wesentlichen vom Basiswiderstand, den Sperrschichtkapazitäten und der Basislaufzeit abhängig. mit einer Verkleinerung der Strukturabmessungen werden dabei zwar die Kapazitäten reduziert, während der Basisbahnwiderstand

- 2 -    VPA    83 P 1728 E    **0141207**

dabei eine Erhöhung erfährt. Ein optimales Verfahren zur deutlichen Reduzierung des Basiswiderstandes ist nun in der genannten Literaturstelle angegeben. Dabei ist die Oberfläche der Basiszone des im Aufwärtsbetrieb arbeitenden npn-Vertikaltransistors der dort beschriebenen $I^2L$-Zelle bis in unmittelbarer Nähe der in die Basiszone eingebetteten Kollektoren mit einer als Basiselektrode dienenden Aluminiumschicht abgedeckt. Der Anschluß für die einzelnen Kollektorzonen des npn-Vertikaltransistors besteht, wie bereits oben bemerkt, aus $n^+$-Polysilicium mit einem Schichtwiderstand $R_s$ von etwa 100 Ohm. Wegen des hohen Schichtwiderstands dieser Polysiliciumschichten kann eine solche Transistorstruktur nur im Aufwärtsbetrieb, also z.B. für $I^2L$-Logik, verwendet werden. Würde man andererseits anstelle der Polysiliciumelektroden Elektroden aus Metall für die Kontaktierung der in die Basiszone eingebetteten n-dotierten Zonen anwenden, so könnte man jedoch das wegen der Strukturverkleinerung vorteilhafte beschriebene Herstellungsverfahren nicht anwenden, weil ein geeignetes temperaturbeständiges und zugleich haftfestes Metall nicht zur Verfügung steht. Außerdem dient bei dem in der genannten Literaturstelle beschriebenen Verfahren die vorgesehene polykristalline Siliciumelektrode als Dotierungsquelle bei der Herstellung der zugehörigen Kollektorzone durch Diffusion.

Es ist nun Aufgabe der Erfindung, eine Möglichkeit anzugeben, welches die Anwendung des bekannten vorteilhaften Herstellungsverfahrens erlaubt und dennoch ein Transistor nicht nur mit niedrigem Basiswiderstand entsteht, sondern daß der Transistor auch beim Abwärtsbetrieb voll funktionsfähig ist.

Hierzu wird gemäß der Erfindung vorgeschlagen, daß der für den in die Basiszone eingebetteten weiteren n-leitenden Bereich vorgesehene Kontakt an seiner mit dem einkristallinen Silicium in Berührung stehenden Unterseite aus $n^+$-dotiertem polykristallinen Silicium und an seiner Oberseite aus einem Silicid besteht, welches als zweiten Bestandteil eines der Elemente Tantal, Titan, Wolfram oder Molybdän enthält.

Dabei ist in Weiterbildung der Erfindung vorgesehen,
daß zwecks weiterer Kontaktierung des von der Basiszone
umgebenen n-leitenden Bereichs die in ihrem an den n-leitenden Bereich angrenzenden unteren Teil aus $n^+$-dotiertem
polykristallinen Silicium und in ihrem vom Halbleiterkörper
abgewandten Teil aus einem der genannten Metallsilicide bestehenden Doppelschichtelektrode seitlich sich auf einer
isolierenden Zwischenschicht über die Grenze des weiteren
n-leitenden Bereichs hinauserstreckt und die Berührungsstelle zwischen einem, z.B. aus Aluminium bestehenden,
weiteren Kontakt (z.B. einer Aluminiumleitbahn) und der
Silicidschicht der Doppelschichtelektrode sich auf den
über die Grenze hinausragenden Teil der Doppelschichtelektrode beschränkt.

Durch eine der oben gegebenen Definition der Erfindung
entsprechende Kontaktierung des innerhalb der p-leitenden Basiszone angeordneten n-leitenden Bereiches lassen
sich Schichtwiderstände $R_s$ für die Kontaktierung dieses
Bereiches bzw. dieser Bereiche von 1 Ohm ohne weiteres
erreichen, so daß der Transistor sowohl im Aufwärtsbetrieb als auch im Abwärtsbetrieb eingesetzt werden kann.
Außerdem lassen sich die für Transistoren mit geringer
lateraler Ausdehnung günstigen Herstellungsverfahren
ohne Schwierigkeiten auch bei der Herstellung des erfindungsgemäßen Transistors anwenden.

Die Erfindung wird nun anhand der Figuren 1 bis 3 und
des nun zu beschreibenden Herstellungsverfahrens näher
vorgestellt. Dabei ist in Fig. 1 das Layout einer bevorzugten Ausgestaltung des erfindungsgemäßen Transistors
und in Fig. 2 bzw. Figur 3 je ein senkrecht zum Layout
gelegter Schnitt gezeigt, wobei die beiden Schnitte ebenfalls senkrecht zueinander orientiert sind.

Zu Beginn des Herstellungsverfahrens für einen npn-Transistor gemäß der vorliegenden Erfindung wird an der Oberfläche eines p-dotierten Substrats aus monokristallinem Silicium die Grundlage für eine $n^+$-buried-layer-Zone geschaffen, was z.B. durch maskierte Implantation von Antimonionen geschehen kann. Anschließend wird die so behandelte Substratoberfläche mit einer n-dotierten monokristallinen Siliciumschicht epitaktisch abgedeckt. In der epitaktischen Schicht wird dann oberhalb des buried-layer-Bereichs . der Transistor gemäß der Erfindung derart hergestellt, daß mit Abstand von der buried-layer-Zone die Basis . des Transistors und die in diese eingebettete und bevorzugt als Emitter betriebene $n^+$-Zone entstehen. Da der herzustellende Transistor im Gegensatz zu dem aufgrund des Herstellungsverfahrens nach der Literaturstelle "IEDM 1979 Dig. Tech.Pap.", S. 201- 204 entstehenden Transistors für den Abwärtsbetrieb geeignet ist, soll für das Weitere der an den buried-layer-Bereich angrenzende n-leitende Teil der epitaktischen Schicht als Kollektor und der an die Basiszone gegenüber dem Kollektor angrenzende und z.B. in ihr eingebettete $n^+$-dotierte Bereich als der Emitter des Transistors bezeichnet werden. Natürlich können Emitter und Kollektor beim Betrieb des Transistors ihre Rollen tauschen.

Nach Durchführung des Epitaxieprozesses wird bevorzugt die epitaktische Siliciumschicht zunächst durch partielle Oxydation in Wannen aufgeteilt, von denen eine für die Aufnahme des herzustellenden Transistors bestimmt ist. Die partielle Oxydation der epitaktischen Siliciumschicht erfolgt in üblicher Weise unter Verwendung einer Oxydationsmaske aus Siliciumnitrid, die in üblicher Weise erzeugt und durch Photolack-Ätztechnik geformt wird. Da die durch die partielle Oxydation entstehende $SiO_2$-Schicht die Aufgabe hat, den Bereich des herzustellenden Transistors gegenüber weiteren in der epitaktischen Schicht zu erzeugenden Halbleiterelementen zu isolieren, wird die entstehende $SiO_2$-Schicht

bis zum Substrat vorgetrieben. Sie ist in den Zeichnungen mit 2 bezeichnet, während 1 den buried-layer-Bereich, 9 den zwischen dem buried-layer-Bereich 1 und der Basiszone 4 liegenden und durch den Rest der ursprünglichen epitaktischen Schicht gegebenen n-leitenden Kollektor und 10 das Substrat bedeutet.

Die entstandene Isolationsoxydschicht 2 wird nunmehr in üblicher Weise als Dotierungsmaske bei der Herstellung der p-leitenden Basiszone 4 verwendet, deren Dotierung beispielsweise durch Borimplantation eingebracht wird. Anschließend wird die durch die Einbringung der Basisdotierung behandelte Oberfläche der epitaktischen Schicht mit einer $n^+$-dotierten polykristallinen Siliciumschicht abgedeckt, wobei sich für die Dotierung der polykristallinen Siliciumschicht insbesondere Arsen eignet. Dann wird die erhaltene polykristalline Siliciumschicht mit einer Schicht aus einem der genannten Silicide, insbesondere aus Ta $Si_2$, abgedeckt. Die polykristalline Siliciumschicht wird z.B. durch thermische Zersetzung von $SiH_4$ bei etwa 600°C an der Oberfläche der zu behandelnden Anordnung abgeschieden. Sie wird dann durch eine Silicidschicht der genannten Art, also $TaSi_2$ bzw. $TiSi_2$ bzw. $WSi_2$ bzw. $MoSi_2$ abgedeckt. Eine solche Silicidschicht kann z.B. durch Aufdampfen oder Aufsputtern aufgebracht werden. Man kann aber auch zunächst eine Schicht aus dem in der gewünschten Silicidschicht vorgesehenen Metall, z.B. eine Tantalschicht durch Aufdampfen oder Aufsputtern auf die polykristalline Siliciumschicht aufbringen, um sie dann durch einen Temperaturprozeß in das gewünschte Silicid durch Reaktion mit der aus polykristallinem Silicium bestehenden Unterlage umzuwandeln. Die Stärke der $n^+$-polykristallinen Siliciumschicht beträgt z.B. 0,2 - 0,5 µm, die Stärke der Metallsilicidschicht z.B. 0,2 - 0,5 µm. Die Dotierung der polykristallinen Siliciumschicht besteht, wie bereits angedeutet, vorwiegend aus Arsen, während sich für die Dotierung der buried-layer-Zone 1 Antimon oder auch Arsen eignet.

Für die Herstellung der polykristallinen Siliciumschicht empfiehlt sich vor allem folgendes Vorgehen:

Zunächst wird durch thermische Zersetzung oder durch Zersetzung durch Plasmaentladung unter Verwendung eines siliciumhaltigen geeigneten Reaktionsgases, z.B. von $SiH_4$, die polykristalline Siliciumschicht mit einer Stärke von etwa 0,2 - 0,5 µm abgeschieden. Zur Erzielung der Dotierung kann dabei dem Reaktionsgas eine gasförmige Arsenverbindung, z.B. $AsH_3$ beigemischt sein. Man kann aber auch die Dotierung nachträglich durch Implantation einbringen, was zweckmäßig vor der Abdeckung der Polysiliciumschicht mit der Silicidschicht geschieht.

Die Silicidschicht ist ebenfalls zweckmäßig auf eine Dicke von etwa 0,2 bis 0,5 µm einzustellen. Sie besteht aus einem der Silicide $TaSi_2$, $TiSi_2$, $WSi_2$ oder $MoSi_2$. Nach Herstellung der Silicidschicht wird die aus ihr und der darunter befindlichen polykristallinen Siliciumschicht bestehende Doppelschicht strukturiert, was in üblicher Weise durch Photolack-Ätztechnik geschieht. Die auf der polykristallinen Siliciumschicht aufgebrachte Silicidschicht bedingt einen niedrigen Schichtwiderstand $R_s$ ($\approx 1\Omega$) für die aus der Doppelschicht gebildete Emitterelektrode und und ist außerdem für die nunmehr für die Herstellung der Basiszone und der Emitterzone erforderliche Hochtemperaturbehandlung ausreichend stabil. Diese findet bei einer Temperatur von 900 - 1000°C statt und hat die Aufgabe, aus der polykristallinen Siliciumschicht Dotierungsstoff in das darunterbefindliche und für den Emitter vorgesehene Gebiet der epitaktischen Schicht unter Entstehung der Emitterzone des Transistors einzubringen und ihre endgültige Gestalt sowie die endgültige Gestalt der Basiszone 4 festzulegen.

Festzustellen ist dabei, daß die seitliche Begrenzung der Emitterzone teils durch die laterale Abmessung der

- 7 -   VPA   83 P 0141207 E

polykristallinen Siliciumschicht und teils durch eine
maskierende Wirkung der Oxydisolation bestimmt werden
kann. Auf jeden Fall ist darauf zu achten, daß die Oberfläche der epitaktischen Schicht am Ort der Basiszone
für eine Kontaktstelle der Basiszone unbedeckt bleibt,
so daß aufgrund der nunmehr durch Aufdampfen oder Aufsputtern aufzubringenden Aluminiummetallisierung eine
Basiselektrode gebildet werden kann. Ebenso muß eine
der Kontaktierung der Kollektorzone dienende Verbindung
aus n- bzw. $n^+$-dotiertem Silicium zwischen dem die Kollektorzone bildenden n-dotierten und zwischen der erzeugten p-dotierten Basiszone und der buried-layer-Zone
liegenden Rest der ursprünglichen epitaktischen Schicht
gewährleistet sein. Beiden Forderungen ist in der aus
Fig. 1 - 3 ersichtlichen Ausgestaltung eines der Erfindung entsprechenden npn-Transistors Rechnung getragen.

In Fig. 1 - 3 bedeuten:

1 = buried-layer-Bereich;   2 = Isolationsoxyd;
3 = $n^+$-Kollektoranschlußzone;   4 = Basiszone;
5 = Emitterzone;   6 = $n^+$-Polysilicium;
7 = Silicidschicht;   8 = $SiO_2$-Schicht;
9 = Kollektorzone;   10 = p-Substrat;
E = Emitteranschluß;   B = Basisanschluß;
C = Kollektoranschluß.

Dabei ist unter dem Begriff "Emitteranschluß E" nicht
der aus der polykristallinen Siliciumschicht 6 und der
Silicidschicht 7 bestehende unmittelbare Anschluß der
Emitterzone 5 sondern die abseits der Emitterzone 5 lokalisierte und oberhalb des Isolationsoxyds 2 befindliche und z.B. - ebenso  wie der Kollektoranschluß C
und der Basisanschluß B aus Metall, insbesondere aus
Aluminium bestehende externe Anschluß der Polysilicium-
Metallsilicid -Doppelschicht 6, 7 zu verstehen.

Wie man aus Fig. 2 erkennt, ist der aus Aluminium bestehende Basisanschluß B beiderseits eines zentralen Vorsprungs der doppelschichtigen Emitterelektrode 6, 7 angeordnet, während der Ort für die Kollektorelektrode C (vgl. Fig. 3) durch einen Teil der Isolationsoxydschicht 2 von der Kontaktierungsstelle der Emitterzone 5 und der Basiszone 4 an der Halbleiteroberfläche getrennt ist.

An die aus Polysilicium und Silicid bestehende Doppelschicht 6, 7 werden folgende Anforderungen gestellt:

a) ein niedriger Schichtwiderstand für die Emitterkontaktierung;

b) die Verwendbarkeit als Dotierungsquelle für die Herstellung der Emitterzone 5;

c) sie soll für Temperaturen von wenigstens $900^{o}$C temperaturstabil sein;

d) sie soll mit dem der Herstellung des Transistors dienenden Gesamtprozeß verträglich sein.

Diese Forderungen werden von einer Doppelschicht aus $n^{+}$-dotiertem polykristallinem Silicium 6 und einem Silicid der genannten Metalle Ta, Ti, Mo, W, insbesondere $TaSi_2$, $MoSi_2$, $WSi_2$, erfüllt. Besonders günstig ist dabei die Verwendung von $TaSi_2$. Letzteres kann man bekanntlich durch thermische Reaktion zwischen elementarem Silicium und elementarem Tantal im Temperaturbereich von $300^{o}$ - $700^{o}$C erhalten. Der spezifische Widerstand von $TaSi_2$ beträgt $60 /u\Omega \cdot$ cm, was z.B. für eine 300 nm dicke $TaSi_2$-Schicht zu einem Schichtwiderstand $R_s = 2 \Omega$ führt. Für die aus Fig. 2 ersichtliche Transistorstruktur bedeutet dies zwar einen zusätzlichen Emitterwiderstand von etwa $5\Omega$. Jedoch wirkt sich ein solcher Widerstand wegen seiner gegenkoppelnden Wirkung nicht negativ auf das dynamische Verhalten des Transistors aus.

Die in Fig. 1-3 dargestellte Transistorstruktur bringt folgende Vorteile:

1.) Äußerer Basiswiderstand $R_B \approx 0\ \Omega$;

2.) Selbstjustierender Basis-Emitter-Komplex;

3.) Kleinstmögliche Emitterfläche (gemeinsame Fläche zweier sich überdeckender Streifen);

4.) Sehr kleine Basisfläche und damit eine entsprechend kleine C-B-Kapazität;

5.) Keine zusätzliche Photolacktechnik erforderlich;

6.) Verwendung der Silicidschicht 7 als Verdrahtungsebene;

7.) Der Transistor ist sowohl für den Aufwärts- als auch für den Abwärtsbetrieb geeignet.

Zu Punkt 3 ist noch zu vermerken, daß die Emitterfläche bei dem gezeichneten Ausführungsbeispiel (vgl. Fig. 2 und 3) einerseits durch die Geometrie der Basiszone 4 und andererseits durch die Geometrie der polykristallinen $n^+$-Siliciumschicht 6 bestimmbar ist. Dabei ist es möglich, die beiden Geometrien in Gestalt sich überkreuzender Streifen zu realisieren. Da es möglich ist, hier eine minimale Streifenbreite von $3\,\mu m$ zu realisieren, kann man eine Emitterfläche von minimal $3 \times 3\,\mu m^2$ erreichen. Bei der üblichen Herstellung des Emitters mittels Diffusionsfenster in einer $SiO_2$-Maskierungsschicht läßt sich jedoch erfahrungsgemäß nur ein Minimum von $5 \times 5\,\mu m^2$ erreichen.

Schließlich ist im Zusammenhang mit Fig. 2 und Fig. 3 noch darauf aufmerksam zu machen, daß die Doppelschicht-Kontaktelektrode 6, 7 der n-leitenden Emitterzone 5 mit einer insbesondere aus $SiO_2$ bestehenden Isolierschicht 8 abgedeckt ist, welche ihrerseits als Träger für die Basiselektrode B dienen kann. Letzteres ist in dem bevorzugten Ausführungsbeispiel gemäß Fig. 1 - 3 vorgesehen. Zur Herstellung der $SiO_2$-Schicht 8, die zweckmäßig vor der der Erzeugung der Emitterzone 5 dienenden Temperaturbehandlung erfolgt, kann man z.B. das in der Literaturstelle "IEEE Transactions on Electron Devices, Vol. ED-28, No. 9 (September 1981), S. 1010 - 1013 (vgl. insbes. S. 1010)" beschriebene Verfahren anwenden.

8 Patentansprüche
3 Figuren

**0141207**

Patentansprüche

1.) Integrierbarer npn-Transistor mit niedrigem Basiswiderstand, der in einem einkristallinen Siliciumkörper erzeugt ist und bei dem die p-dotierte Basiszone an der einen Seite an einen - insbesondere den Kollektor des Transistors bildenden - ersten n-leitenden Bereich des Siliciumkörpers und an der gegenüberliegenden Seite an einen weiteren - insbesondere den Emitter des Transistors bildenden - weiteren n-leitenden Bereich angrenzt, der von dem ersten n-leitenden Bereich getrennt ist und einen Kontakt aufweist, der teilweise aus $n^+$-dotiertem polykristallinen Silicium besteht und der als Dotierungsquelle bei der Herstellung des weiteren n-dotierten Bereiches verwendet wurde, dadurch gekennzeichnet, daß der für den an die Basiszone (4) angrenzenden weiteren n-leitenden Bereich (5) vorgesehene Kontakt an seiner mit dem einkristallinen Silicium (5) in Berührung stehenden Unterseite (6) aus $n^+$-dotiertem polykristallinen Silicium und an seiner Oberseite (7) aus einem Silicid besteht, welches als zweiten Bestandteil eines der Elemente Tantal, Titan, Wolfram oder Molybdän enthält.

2.) npn-Transistor nach Anspruch 1, dadurch gekennzeichnet, daß die Oberseite (7) des als Doppelschicht ausgebildeten Kontakts ((6, 7) aus einem der Silicide $TaSi_2$, $MoSi_2$, $TiSi_2$ oder $WSi_2$ besteht.

3.) npn-Transistor nach Anspruch 2, dadurch gekennzeichnet, daß die Stärke jeder der beiden Teilschichten (6, 7) auf 0,2 - 0,5 um eingestellt ist.

4.) npn-Transistor nach einem der Ansprüche 1 bis 3, dadurch gekennzeichnet, daß zwecks weiterer Kontaktierung des von der Basiszone (4) umgebenen weiteren n-leitenden Bereichs (5) die diesen kontaktierende Doppelschicht (6, 7) auf einer isolierenden Schicht (2) seitlich über die Grenze des weiteren n-leitenden Bereichs (5) hinausgeführt ist und die Berührungsstelle zwischen einem z.B. aus Al bestehenden weiteren Anschlußkontakt (E) und der Silicidschicht (7) des Doppelschichtkontakts (6,7) sich auf den über die Grenze des weiteren n-leitenden Bereichs (5) hinausragenden Teil der Doppelschichts (6, 7) beschränkt.

5.) Verfahren zur Herstellung eines npn-Transistors nach einem der Ansprüche 1 bis 4, dadurch gekennzeichnet, daß nach der Herstellung des ersten n-leitenden Bereichs (9) dessen Oberfläche am Ort der zu erzeugenden Basiszone (4) unter Verwendung einer entsprechenden Maskierung (2) einer Borimplantation ausgesetzt wird, daß dann am Ort des zu erzeugenden weiteren n-leitenden Bereichs (5) der durch die Borimplantation behandelte Teil der Oberfläche des Siliciumkörpers mit einer $n^+$-dotierten polykristallinen Siliciumschicht (6) versehen und die dann zur Erzeugung des weiteren n-leitenden Bereichs (5) als Dotierungsquelle zu verwende-polykristalline Siliciumschicht (6) mit einer Abdeckung aus einem der genannten Metallsilicide versehen und auf ihre endgültige Gestalt gebracht wird, und daß schließlich eine der Erzeugung der endgültigen Gestalt der Basiszone sowie zur Erzeugung der weiteren n-leitenden Zone (5) dienende Wärmebehandlung vorgenommen wird.

6.) Verfahren nach Anspruch 5, dadurch gekennzeichnet, daß zur lateralen Begrenzung der Basiszone (4) und gegebenenfalls eines Teils des weiteren n-leitenden Bereichs (5) eine sowohl als Isolation als auch als Dotierungsmaske dienende $SiO_2$-Schicht (2) an der Oberfläche des Siliciumkörpers erzeugt wird.

7.) Verfahren nach Anspruch 6, dadurch gekennzeichnet, daß die eine Oberflächeseite eines aus p-leitendem monokristallinen Silicium bestehenden Substrats (10) an der für den Transistor bestimmten Stelle zunächst mit einer buried-layer-Zone (1) mit $n^+$-Dotierung versehen und dann mit einer n-dotierten epitaktischen Schicht bedeckt wird, daß dann durch einen maskierten Oxydationsprozeß der für die Basiszone (4) und den weiteren n-leitenden Bereich (5) vorgesehene Teil der epitaktischen Schicht wenigstens teilweise von einer bis zum Substrat (10) reichenden Isolationsoxydschicht (2) umgeben wird und diese als Dotierungsmaske bei der Herstellung der Basiszone (4) und des weiteren n-leitenden Bereichs (5) verwendet wird.

8.) Verfahren nach Anspruch 7, dadurch gekennzeichnet, daß die buried-layer-Zone (1) abseits von der Basiszone (4) und dem weiteren n-leitenden Bereich (5) einen elektrischen Anschluß (3,C) erhält, daß ferner nach Formung des zur Kontaktierung des weiteren n-leitenden Bereichs (5) dienenden Doppelschichtkontakts (6,7) dieser mit einer Oxydschicht (8) abgedeckt und auf dieser Oxydschicht (8) eine der Kontaktierung der Basiszone (4) dienende Al-Schicht (B) aufgebracht wird.

0141207

1/1

FIG 2

FIG 1

FIG 3